# EUROPÄISCHE PATENTSCHRIFT

(11) **EP 0 601 374 B1**
(45) Veröffentlichungstag und Bekanntmachung des Hinweises auf die Patenterteilung: **04.06.1997**
(21) Anmeldenummer: 93118732.2
(22) Anmeldetag: 22.11.1993
(51) Int. Cl.: H03J 1/00, H03J 7/18

(54) **Empfangsgerät mit automatisiertem Abgleich bei der Fertigung und Suchlaufstopp mittels Mikrocomputer**
Receiving apparatus with automatic tuning adjustment at fabrication and search stop by means of a microcomputer
Dispositif de réception à procédé d'ajustage automatique lors de la fabrication et arrêt de marche de détection au moyen d'un micro-ordinateur

(30) Priorität: 09.12.1992 DE 4241455
(43) Veröffentlichungstag der Anmeldung: 15.06.1994
(73) Patentinhaber: GRUNDIG Aktiengesellschaft, 90762 Fürth (DE)
(72) Erfinder: Bienefeld, Axel, Grundig E.M.V., D-90748 Fürth (DE)

(56) Entgegenhaltungen:
- US-A- 4 580 285
- US-A- 4 947 456

## Beschreibung

Die Erfindung betrifft einen Funk- bzw. Rundfunkempfänger mit einer Einrichtung zum automatischen Sendersuchlauf gemäß den Patentansprüchen 1 und 2.

Um einen Funk- oder Rundfunkempfänger während eines automatischen Sendersuchlaufs auf eine empfangswürdige Sendefrequenz abzustimmen, ist es notwendig, sowohl die Empfangsfeldstärke z.B. durch Beurteilung der ZF-Amplitude als auch die Frequenzabweichung zwischen dem momentanen Istwert und dem genormten Sollwert der Zwischenfrequenz zu überwachen. Dem Stand der Technik entsprechend sind Schaltungsanordnungen bekannt, bei denen einerseits dem ZF-Verstärker über einen Pegeldetektor ein Steuersignal nach Maßgabe der Empfangsfeldstärke entnommen wird und bei denen andererseits über einen FM-Diskriminator mit separatem Fensterdiskriminator ein Stopsignal für die Suchlaufeinrichtung erzeugt wird, wenn beim Durchstimmen des Tuners die Zwischenfrequenz innerhalb einer bestimmten Toleranzbreite sich dem Sollwert der ZF genähert hat. Nur wenn das aus der Empfangsfeldstärke abgeleitete Steuersignal einen vorzugebenden Wert übersteigt, wird das Stopsignal des Fensterdiskriminators ausgewertet. Ein derartiger Empfänger ist aus der US-A-4 580 285 bekannt.

Häufig wird ein separater Fensterdiskriminator in Verbindung mit einer optischen Anzeige auch als Abstimmhilfe für eine manuelle Senderabstimmung verwendet, wie dies beispielsweise in dem Beitrag "Das Tunoscop im R 2000, R 3000, T 3000" in den "Grundig Technischen Informationen", 1/2-1980, S. 38-40, beschrieben ist. Eine gattungsgleiche Abstimmanzeige ist aus der DE-PS 26 10 605 bekannt.

Da der S-förmige Kennlinienverlauf des FM-Diskriminators und die Schaltgrenzen des Fensterdiskriminators toleranzbehaftet sind, werden in den meisten Fällen Abgleichelemente zur individuellen Festlegung der Sendermittenabstimmung notwendig. Schaltungsanordnungen dieser Art sind deshalb vom Material- und Abgleichaufwand her gesehen verhältnismäßig aufwendig.

Aus der DE 2814577 A1 ist ein Empfänger mit mikrocomputergesteuerter Senderabstimmung bekannt, bei dem der Parallel- und Gleichlauf eines oder mehrerer Vorkreise durch individuell abgespeicherte Abstimmwerte sichergestellt ist. Auch ist die generelle Abspeicherung einer statistisch ermittelten mittleren Abstimmkurve offenbart, wobei diese Kurve individuell über Einstellelemente jedem Gerät angepaßt werden kann.

Die beschriebene Schaltungsanordnung dient zwar dazu, Toleranzen zwischen Vorkreis und Tuner-Abstimmkreis zu eliminieren, gibt aber keinen Hinweis auf eine individuelle Abstimmung auf Sendermitte beim automatischen oder manuellen Sendersuchlauf.

Eine bekannte Methode, einen Empfänger exakt auf Sendermitte abzustimmen, besteht darin, die Frequenz des ZF-Signals auszuzählen und bei Übereinstimmung zwischen dem momentanen Ist- und dem genormten Sollwert den Sendersuchlauf zu stoppen. Hierzu ist jedoch ein zusätzlicher Aufwand in Form eines Frequenzzählers notwendig.

Die US-PS 4,947,456 offenbart einen Funkempfänger mit S-Kurven-Abstimmung, der beim Sendersuchlauf ein Stopsignal auslöst, wenn die aus dem Demodulator gewonnene Gleichspannung einen zwischen zwei fest vorgegebenen Grenzwerten liegenden Wert erreicht, sofern eine im Gerät vorhandene Rauschsperre nicht aktiviert ist. Die Schaltung hat den Nachteil, daß durch Toleranzen der Demodulator-S-Kurve die Sendermitte nur ungenügend genau getroffen wird.

Um FM-Diskriminator-Toleranzen und -Temperaturdriften zu eliminieren, ist es aus der DE 3213870 C2 bekannt, mit Hilfe eines Referenzoszillators die Diskriminator-Ausgangsspannung bei der ZF-Soll-Frequenz zu ermitteln und unter Bezugnahme auf diesen Spannungswert den Überlagerungsoszillator während des Suchlaufs so weit zu verstimmen, daß bei einer Sendermittenabstimmung diesselbe Diskriminator-Ausgangsspannung erzielt wird.

Die Schaltung ist verhältnismäßig aufwendig, da sie neben einer Zeitsteuerschaltung zum zeitlich gezielten Abfragen des Referenzwertes einen zusätzlichen Oszillator und eine Abfrage- und Halteeinrichtung benötigt.

Schließlich ist aus der EPA 0 500 025 eine Schaltungsanordnung zur automatischen Frequenzregelung bekannt, bei der die Frequenz eines ZF-Signals durch Nachsteuern eines Überlagerungsoszillators konstant gehalten wird. Die Schaltung enthält einen Frequenz-/Spannungswandler, einen Analog-/Digitalwandler, einen Mikroprozessor und einen PLL-Synthesizer zur Erzeugung der Überlagerungsfrequenz. Aus dem ZF-Signal wird über den Frequenz-/Spannungswandler ein der Frequenz proportionales Steuersignal gewonnen, das anschließend im A/D-Wandler digitalisiert und im Mikroprozessor mit einem vorgegebenen Sollwert verglichen wird. Das aufgrund dieses Vergleiches gewonnene Korrektursignal wird in Form einer Rückkopplung dem PLL-Synthesizer zugeführt, der die Überlagerungsfrequenz so lange nachzieht, bis die Frequenz des ZF-Signals wieder ihren Sollwert erreicht.

Während sich die zuletzt erwähnte Regelschaltung mit dem Eliminieren einer Frequenzdrift befaßt, ist es Aufgabe der vorliegenden Erfindung, eine kostengünstige Schaltungsanordnung für einen mikrocomputergesteuerten Suchlaufstop anzugeben, bei der ohne hardwaremäßigen Aufwand während des Fertigungsprozesses des Gerätes individuelle Bauteiletoleranzen ausgeglichen werden können.

Diese Aufgabe wird durch die Merkmale des Anspruchs 1 gelöst. Mit Anspruch 2 wird eine weitere fertigungsgerechte Variante der Erfindung aufzeigt.

Der Vorteil der im Anspruch 1 offenbarten Anordnung besteht darin, daß Toleranzen der FM-Diskriminatorkennlinie während des automatisierten Fertigungsprozesses des Gerätes individuell erfaßt werden und daß durch Abspeicherung der ermittelten Eckwerte die Grenzen zum Auslösen eines Stopsignals während eines späteren Sendersuchlaufs dauerhaft vorliegen, ohne daß es dazu besonderer zusätzlicher Bauteile oder Abgleichelemente bedarf. Außerdem hat die Anordnung den Vorteil, daß Abweichungen der momentan eingestellten Empfangsfrequenz von der Sendermittenfrequenz ohne zusätzlichen Hardwareaufwand über eine optische Abstimmhilfe angezeigt werden, was vor allem bei Handabstimmung eine bessere Annäherung an die Sendermitte erlaubt.

Mit der Anordnung nach Anspruch 2 reduziert sich der notwendige Abgleichaufwand während des automatisierten Fertigungsprozesses des Gerätes auf die Messung an nur einem Punkt der FM-Diskriminatorkennlinie, wobei individuell für jedes Gerät der für exakte Sendermittenabstimmung geltende Gleichspannungswert ermittelt und abgespeichert wird.

Die Erfindung wird nachstehend anhand der Zeichnungen näher erläutert.

Es zeigen:
- Fig. 1:: Das Blockschaltbild eines erfindungsgemäßen Empfangsgerätes
- Fig. 2:: Die FM-Diskriminatorkennlinie

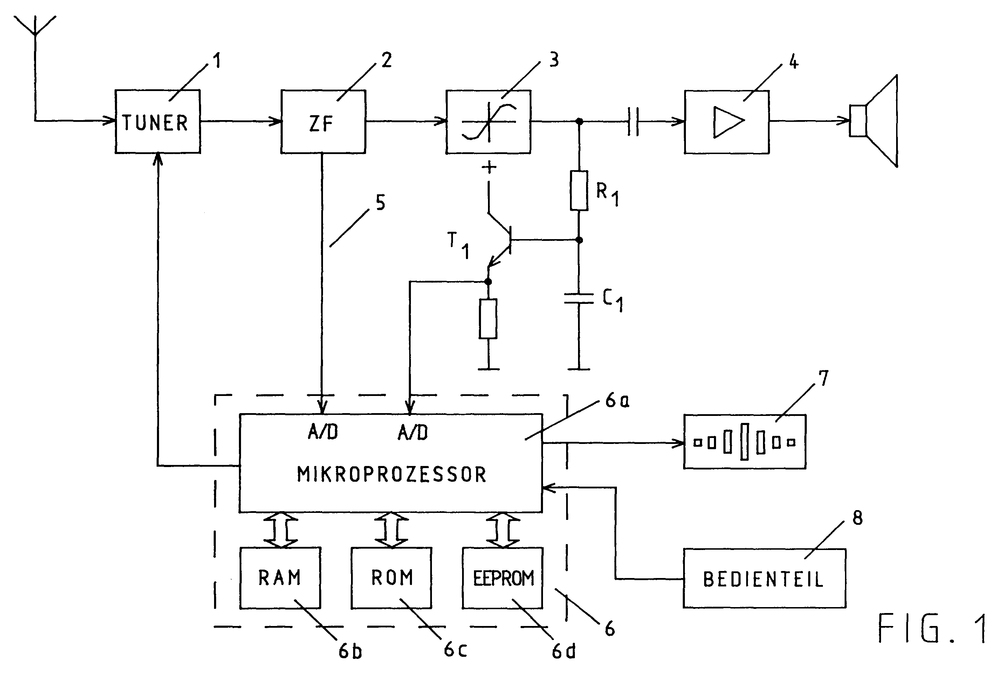

Der in Fig. 1 dargestellte Empfänger besteht in an sich bekannter Weise aus dem Synthesizer-Tuner 1, dem ZF-Verstärker 2, dem als Demodulator wirkenden FM-Diskriminator 3 und der NF-Endstufe 4. Der Synthesizer-Tuner 1 erhält seine Abstimmsignale vom Mikrocomputer 6, der seinerseits aus dem Mikroprozessor 6a, dem Arbeitsspeicher 6b, dem Programmspeicher 6c und dem nichtflüchtigen Speicher 6d besteht. Gesteuert wird der Mikrocomputer 6 über das Bedienteil 8; das Display 7 dient als optische Abstimmhilfe bei manueller Senderwahl.

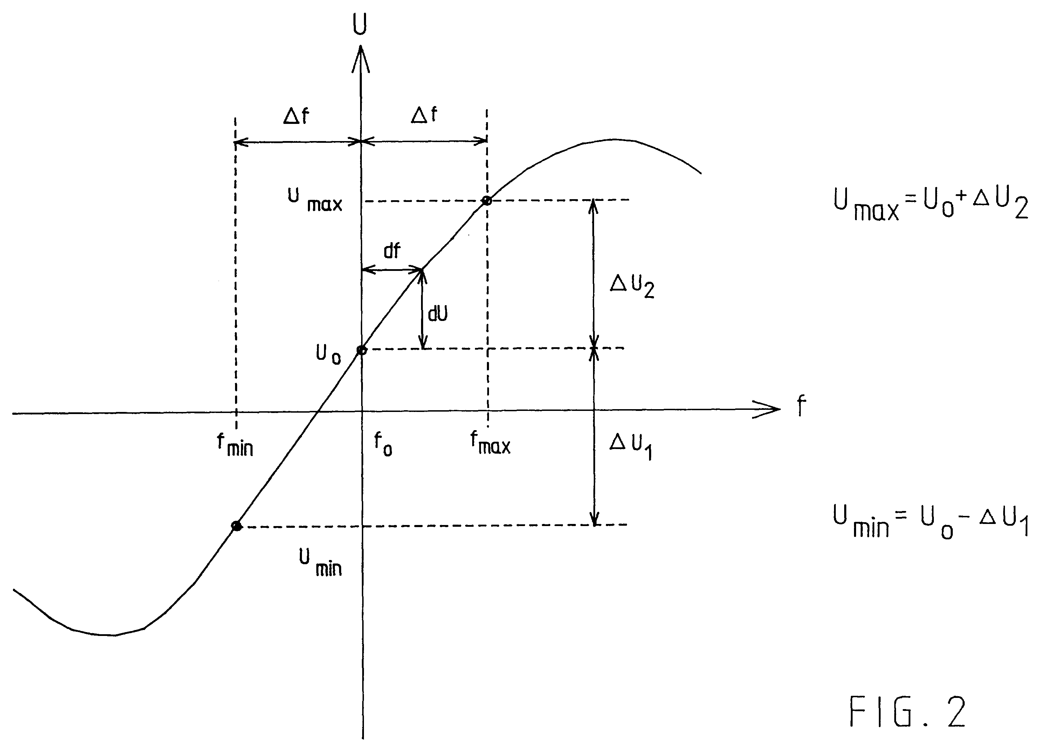

Die in Fig. 2 dargestellte Kennlinie stellt den Verlauf der Gleichspannung am Ausgang des FM-Diskriminators 3 in Abhängigkeit von der Eingangsfrequenz dar, die der demodulierten NF-Spannung überlagert ist. Diese Gleichspannung wird, entsprechend Fig. 1, über den Tiefpaß R₁, C₁ und die Trennstufe T₁ einem ersten Analog/Digitalwandlereingang des Mikroprozessors 6a zugeführt. Die Trennstufe T1 dient dabei der Pegelanpassung und der rückwärtigen Entkopplung des Mikroprozessors 6a vom Endstufeneingang 4, um Störungen, verursacht durch den Mikroprozessor, vom NF-Zweig fernzuhalten.

Vom ZF-Verstärker 2 führt eine Verbindung 5 zu einem zweiten A/D-Wandlereingang des Mikroprozessors 6a, um nach Maßgabe des ZF-Signalpegels ein der Empfangsfeldstärke proportionales Steuersignal an den Mikroprozessor 6a zu liefern.

Zum Abgleich des in Fig. 1 dargestellten Empfängers während des automatisierten Fertigungsprozesses des Gerätes wird der Synthesizer-Tuner 1 mit Hilfe des Bedienteils 8 über den Mikrocomputer 6 auf eine bestimmte Empfangsfrequenz (z.B. f = 97,6 MHz) eingestellt. Dem Antenneneingang des Tuners 1 werden mit Hilfe eines Meßsenders nacheinander zwei Eckfrequenzen (z.B. f₁ = 97,575 MHz und f₂ = 97,625 MHz) zugeführt, die als Fangbereichsgrenzen für einen späteren Sendersuchlauf des Gerätes gelten sollen. Diesen beiden Eckfrequenzen entsprechen die in Fig. 2 dargestellten ZF-Grenzwerte fₘᵢₙ und fₘₐₓ. Aufgrund der Diskriminatorkennlinie ergeben sich hierzu die Gleichspannungswerte Uₘᵢₙ und Uₘₐₓ, die individuell für jedes Gerät nach entsprechender Umwandlung in digitale Zahlenwerte vom Mikroprozessor 6a im nichtflüchtigen Speicher 6d abgelegt werden. Somit stehen dauerhaft die für einen späteren Sendersuchlauf des Gerätes notwendigen Spannungsgrenzwerte zur Verfügung, welche die Fensterbreite 2Δf zum Auslösen eines Stoppbefehls definieren.

Beim Sendersuchlauf während des gebrauchsmäßigen Betriebs des Gerätes wird der Synthesizer-Tuner 1 schrittweise (z.B. in Schrittweiten von 25 kHz) vom Mikrocomputer 6 durchgestimmt. Der dem Ausgang des FM-Diskriminators 3 entnommene Gleichspannungswert U wird nach Tiefpaßfilterung über R₁, C₁ und Pegelanpassung über T₁ im Mikroprozessor 6a in ein digitales Signal gewandelt und mit den im nichtflüchtigen Speicher 6d abgelegten Eckwerten Uₘᵢₙ und Uₘₐₓ verglichen. Sobald die Bedingung Uₘᵢₙ < U < Uₘₐₓ erfüllt ist, stoppt der Mikrocomputer 6 den Sendersuchlauf, sofern gleichzeitig das über die Verbindung 5 dem ZF-Verstärker 2 entnommene Steuersignal zur Beurteilung der Empfangsfeldstärke einen vorgegebenen Grenzwert überschreitet. Sind nicht beide Bedingungen gleichzeitig erfüllt, so setzt der Mikrocomputer den Sendersuchlauf bis zum Erkennen eines empfangswürdigen Senders fort.

Um vor allem bei Handabstimmung dem Gerätebenutzer eine optische Abstimmhilfe anbieten zu können, ist es notwendig, die jeweilige Abweichung dU der Diskriminator-Gleichspannung U vom Gleichspannungswert Uₒ bei Sendermittenempfang auszuwerten und in ein Steuersignal für die Abstimmanzeige 7 umzusetzen. Um während des Fertigungsprozesses des Gerätes keine weitere Messung vornehmen zu müssen, wird entsprechend Anspruch 1 der vorliegenden Erfindung nach Messung der Eckwerte Uₘᵢₙ und Uₘₐₓ der Gleichspannungswert Uₒ für Sendermittenabstimmung näherungsweise als arithmetisches Mittel aus den vorgenannten Eckwerten vom Mikrocomputer 6 errechnet und im nichtflüchtigen Speicher 6d abgelegt. Aus dem statistisch ermittelten Verlauf der Mittelwertskurve der dem FM-Diskriminator 3 entnommenen Gleichspannung U in Abhängigkeit der Frequenz f kann dann zu einer beliebigen Spannungsabweichung dU, bezogen auf den Wert Uₒ, die Frequenzabweichung df zur Sendermitte fₒ bestimmt werden.

Die innerhalb der zugelassenen Fensterbreite 2Δf in Relation zum Gleichspannungswert Uₒ für Sendermittenabstimmung entstehenden maximalen Spannungsabweichungen ΔU₁ und ΔU₂ können durch Unsymmetrie der Diskriminatorkennlinie unterschiedlich groß sein. Ihre absoluten Werte können für eine vorgegebene Fensterbreite 2Δf aus dem statistisch errechneten mittleren Verlauf der Diskriminatorkennlinie gewonnen werden. Gemäß Anspruch 2 der vorliegenden Erfindung wird in vorteilhafter Weise während des Fertigungsprozesses des Gerätes nur der Gleichspannungswert Uₒ für Sendermittenabstimmung gemessen und abgespeichert, indem der Tuner 1 über einen Meßsender mit einer bestimmten Frequenz gespeist und gleichzeitig über den Mikrocomputer 6 auf dieselbe Frequenz abgestimmt wird. Auf diese Weise wird mit nur einer einzigen Messung individuell für jedes Gerät der exakt für Sendermittenabstimmung geltende Gleichspannungswert Uₒ ermittelt und die Eckwerte Uₘᵢₙ und Uₘₐₓ vom Mikrocomputer 6 durch Substraktion der Spannungsdifferenz ΔU₁ bzw. durch Addition der Spannungsdifferenz ΔU₂ errechnet. Mit dieser Lösung kann eine genaue Sendermittenanzeige realisiert werden; die Toleranzen zwischen einzelnen FM-Diskriminatoren werden dabei auf die die Fensterbreite bestimmende Eckfrequenzen fₘᵢₙ und fₘₐₓ übertragen.

Selbstverständlich ist es auch möglich, durch fertigungsseitige Messung bei den drei Frequenzen fₘᵢₙ, fₒ und fₘₐₓ und durch Abspeicherung der dabei ermittelten Spannungswerte Uₘᵢₙ, Uₒ und Uₘₐₓ sämtliche Toleranzen der Diskriminatorkennlinie zu eliminieren.

## Patentansprüche

1. Funk- bzw. Rundfunkempfänger mit einer Einrichtung zum automatischen Sendersuchlauf, bestehend aus einem Synthesizer-Tuner (1), einem ZF-Verstärker (2), einer Anordnung zur Pegeldetektion (5), einem FM-Diskriminator (3) zur Demodulation des NF-Signals und zur Erzeugung einer Steuergleichspannung (U) in Abhängigkeit von der Senderabstimmung sowie einem Mikrocomputer (6) mit nichtflüchtigem Speicher (6d), wobei der Diskriminator (3) über ein Tiefpaßfilter (R₁, C₁) und eine Trennstufe (T₁) direkt mit einem Analog/Digitalwandlereingang (A/D) des Mikrocomputers (6) verbunden ist und der Mikrocomputer (6) während des automatisierten Fertigungsprozesses des Gerätes zur Festlegung der Sendermittenabstimmung durch Einspeisen der einer Fensterbreite (2Δf) entsprechenden Eckfrequenzen (f_{max.}, f_{min.}) die zugehörigen Grenzwerte (U_{max.}, U_{min.}) des vom FM-Diskriminator (3) gelieferten Gleichspannungswertes (U) individuell ermittelt, den Gleichspannungswert (Uₒ) zur Bestimmung der Sendermitte als arithmetischen Mittelwert aus den Grenzwerten (U_{max.}, U_{min.}) errechnet und die drei gerätespezifischen Werte im nichtflüchtigen Speicher (6d) ablegt, um beim späteren gebrauchsmäßigen Betrieb des Gerätes während eines manuellen oder automatischen Sendersuchlaufs den vom FM-Diskriminator (3) aktuell gelieferten Gleichspannungswert (U) mit den im Speicher (6d) abgelegten Grenzwerten (U_{max.}, U_{min.}) und dem Gleichspannungswert (Uₒ) für Sendermitte vergleichen zu können, wobei das schrittweise Durchstimmen des Synthesizer-Tuners (1) gestoppt wird, wenn der aktuell ermittelte Gleichspannungswert (U) in das durch die Grenzwerte (U_{max.}, U_{min.}) definierte Toleranzfenster fällt, sofern gleichzeitig die Pegeldetektoreinrichtung (5) ausreichende Empfangsfeldstärke signalisiert, und wobei die momentane Frequenzabweichung (df) von der Sendermitte durch Auswerten des vom FM-Diskriminator (3) gelieferten Gleichspannungswertes (U) im Vergleich zum errechneten Mittelwert (Uₒ) mit Hilfe der Abstimmanzeige (7) dargestellt wird.

2. Funk- bzw. Rundfunkempfänger mit einer Einrichtung zum automatischen Sendersuchlauf, bestehend aus einem Synthesizer-Tuner (1) einem ZF-Verstärker (2), einer Anordnung zur Pegeldetektion (5), einem FM-Diskriminator (3) zur Demodulation des NF-Signals und zur Erzeugung einer Steuergleichspannung (U) in Abhängigkeit der Senderabstimmung sowie einem Mikrocomputer (6) mit nichtflüchtigem Speicher (6d), wobei der Diskriminator (3) über ein Tiefpaßfilter (R₁, C₁) und eine Trennstufe (T₁) direkt mit einem Analog-Digitalwandlereingang (A/D) des Mikrocomputers (6) verbunden ist und der Mikrocomputer (6) während des automatisierten Fertigungsprozesses des Geräts durch Einspeisen der Sendermittenfrequenz (fₒ) den vom FM-Diskriminator (3) gelieferten Gleichspannungswert (Uₒ) ermittelt, mit Hilfe der vorgegebenen Toleranzwerte (-ΔU₁, +ΔU₂) die für eine maximale Frequenzverstimmung (±Δf) geltenden Grenzwerte (U_{max.}, U_{min.}) errechnet und die drei gerätespezifischen Werte im nichtflüchtigen Speicher (6d) ablegt, um beim späteren gebrauchsmäßigen Betrieb während eines manuellen oder automatischen Sendersuchlaufs den vom FM-Diskriminator (3) aktuell gelieferten Gleichspannungswert (U) mit den im Speicher (6d) abgelegten Grenzwerten (U_{max.}, U_{min.}) und dem Gleichspannungswert (Uₒ) für Sendermitte vergleichen zu können, wobei das schrittweise Durchstimmen des Synthesizer-Tuners (1) gestoppt wird, wenn der aktuell ermittelte Gleichspannungswert (U) in das durch die Grenzwerte (U_{max.}, U_{min.}) definierte Toleranzfenster fällt, sofern gleichzeitig die Pegeldetektoreinrichtung (5) ausreichende Empfangsfeldstärke signalisiert, und wobei die momentane Frequenzabweichung (df) von der Sendermitte durch Auswerten des vom FM-Diskriminator (3) gelieferten Gleichspannungswertes (U) im Vergleich zum abgespeicherten Gleichspannungswert (Uₒ) für Sendermitte mit Hilfe der Abstimmanzeige (7) dargestellt wird.

## Claims

1. Radio receiver or broadcast receiver having an automatic station-search device, comprising a synthesizer tuner (1), an IF amplifier (2), a level-detection arrangement (5), an FM discriminator (3) for demodulating the AF signal and for generating a control direct voltage (U) as a function of the station tuning and also a microcomputer (6) having nonvolatile memory (6d), wherein the discriminator (3) is connected directly to an analog/digital converter input (A/D) of the microcomputer (6) via a low-pass filter (R₁, C₁) and a separator stage (T₁) and the microcomputer (6) individually determines the associated limit values (U_{max.}, U_{min.}) of the direct voltage value (U) supplied by the FM discriminator (3) during the automated manufacturing process of the appliance in order to set the station centre tuning by feeding in the cut-off frequencies (f_{max.}, f_{min.}) corresponding to a window width (2Δf), calculates the direct voltage value (Uₒ) for determining the station centre as the arithmetical mean value of the limit values (U_{max.}, U_{min.}) and stores the three appliance-specific values in the nonvolatile memory (6b) in order to be able to compare the direct voltage value (U) currently supplied by the FM discriminator (3) with the limit values (U_{max.}, U_{min.}) stored in the memory (6d) and the direct voltage value (Uₒ) for station centre in the subsequent in-service operation of the appliance during a manual or automatic station search, wherein the stepwise tuning of the synthesizer tuner (1) is stopped if the currently determined direct voltage value (U) falls within the tolerance window defined by the limit values (U_{max.}, U_{min.}), provided the level-detector device (5) simultaneously signals adequate received field strength, and wherein the instantaneous frequency deviation (df) from the station centre is displayed by evaluating the direct voltage value (U) supplied by the FM discriminator (3) compared with the calculated mean value (Uₒ) with the aid of the tuning indicator (7).

2. Radio receiver or broadcast receiver having an automatic station-search device, comprising a synthesizer tuner (1), an IF amplifier (2), a level-detection arrangement (5), an FM discriminator (3) for demodulating the AF signal and for generating a control direct voltage (U) as a function of the station tuning and also a microcomputer (6) having nonvolatile memory (6d), wherein the discriminator (3) is connected directly to an analog/digital converter input (A/D) of the microcomputer (6) via a low-pass filter (R₁, C₁) and a separator stage (T₁) and the microcomputer determines the direct voltage value (Uₒ) supplied by the FM discriminator (3) during the automated manufacturing process of the appliance by feeding in the station centre frequency (fₒ), calculates the limit values (Uₘₐₓ, Uₘᵢₙ) valid for a maximum frequency detuning (±Δf) with the aid of the preset tolerance values (-ΔU₁, +ΔU₂) and stores the three appliance-specific values in the nonvolatile memory (6d) in order to be able to compare the direct voltage value (U) currently supplied by the FM discriminator (3) with the limit values (U_{max.}, U_{min.}) stored in the memory (6d) and the direct voltage value (Uₒ) for station centre in the subsequent in-service operation during a manual or automatic station search, wherein the stepwise tuning of the synthesizer tuner (1) is stopped if the direct voltage value (U) currently determined falls within the tolerance window defined by the limit values (U_{max.}, U_{min.}), provided the level-detector device (5) simultaneously signals adequate received field strength, and wherein the instantaneous frequency deviation (df) from the station centre is displayed by evaluating the direct voltage value (U) supplied by the FM discriminator (3) compared with the stored direct voltage value (Uₒ) for station centre with the aid of the tuning indicator (7).

## Revendications

1. Récepteur radio ou récepteur de radiodiffusion comportant un dispositif pour la recherche automatique d'émetteurs, constitué par un tuner-syntoniseur (1), un amplificateur de fréquence intermédiaire (2), un dispositif de détection de niveau (5), un discriminateur FM (3) pour démoduler le signal à basse fréquence et pour produire une tension continue de commande (U) en fonction du réglage d'accord sur un émetteur, ainsi qu'un micro-ordinateur (6) comportant une mémoire non volatile (6d), dans lequel le discriminateur (3) est relié directement à une entrée (A/D) d'un convertisseur analogique/numérique du micro-ordinateur (6) par l'intermédiaire d'un filtre passe-bas (R₁, C₁) d'un étage séparateur (T₁), et, pendant le processus de fabrication automatisé de l'appareil, pour la détermination du réglage d'accord sur une fréquence centrale de l'émetteur par introduction des fréquences limites (f_{max.}, f_{min.}) correspondant à une largeur de fenêtre (2Δf), le micro-ordinateur (6) détermine individuellement les valeurs limites associées (U_{max.}, U_{min.}) de la valeur de tension continue (U) délivrée par le discriminateur FM (3), calcule la valeur de tension continue (Uₒ) pour déterminer la fréquence centrale de l'émetteur en tant que valeur moyenne arithmétique à partir des valeurs limites (U_{max.} , U_{min.}) et mémorise les trois valeurs spécifiques à l'appareil dans la mémoire non volatile (6d), pour pouvoir, lors d'un fonctionnement ultérieur de l'appareil adapté à l'utilisation, comparer la valeur de tension continue (U) délivrée actuellement par le discriminateur FM (3) aux valeurs limites (U_{max.}, U_{min.}) mémorisées dans la mémoire (6d) et à la valeur de tension continue (Uₒ) pour la fréquence centrale de l'émetteur, pendant une recherche manuelle ou automatique de l'émetteur, et dans lequel le réglage d'accord pas-à-pas du tuner-syntoniseur (1) est arrêté lorsque la valeur de tension continue (U) déterminée actuellement se situe dans la fenêtre de tolérance définie par les valeurs limites (U_{max.}, U_{min.}), dans la mesure où simultanément le dispositif de détection de niveau (5) signale une intensité de champ de réception suffisante, et dans lequel l'écart instantané en fréquence (df) par rapport à la fréquence centrale de l'émetteur est représenté par évaluation de la valeur de tension continue (U), délivrée par le discriminateur FM (3), par rapport à la valeur moyenne calculée (Uₒ), à l'aide du dispositif (7) d'affichage de réglage d'accord.

2. Récepteur radio ou récepteur de radiodiffusion comportant un dispositif pour la recherche automatique d'émetteurs, constitué par un tuner-syntoniseur (1), un amplificateur de fréquence intermédiaire (2), un dispositif de détection de niveau (5), un discriminateur FM (3) pour démoduler le signal à basse fréquence et pour produire une tension continue de commande (U) en fonction du réglage d'accord sur l'émetteur, ainsi qu'un micro-ordinateur (6) comportant une mémoire non volatile (6d), dans lequel le discriminateur (3) est relié directement à une entrée (A/D) d'un convertisseur analogique/numérique du micro-ordinateur (6) par l'intermédiaire d'un filtre passe-bas (R₁, C₁)et d'un étage séparateur (T₁), et, pendant le processus de fabrication automatisé de l'appareil, le micro-ordinateur (6) détermine, au moyen de l'introduction de la fréquence centrale (fₒ) de l'émetteur la valeur de tension continue (Uₒ) délivrée par le discriminateur FM (3), calcule, à l'aide des valeurs de tolérance prédéterminées (-ΔU₁, +ΔU₂) les valeurs limites (U_{max.}, U_{min.}) valables pour le désaccord maximum de fréquence (±Δf) et mémorise les trois valeurs, spécifiques à l'appareil, dans la mémoire non volatile (6d), pour pouvoir, lors d'un fonctionnement ultérieur de l'appareil adapté à l'utilisation, comparer la valeur de tension continue (U) délivrée actuellement par le discriminateur FM (3) aux valeurs limites (U_{max.}, U_{min.}) mémorisées dans la mémoire (6d) et à la valeur de tension continue (Uₒ) pour la fréquence centrale de l'émetteur, pendant une recherche manuelle ou automatique d'un émetteur, et dans lequel le réglage d'accord pas-à-pas du tuner-syntoniseur (1) est arrêté lorsque la valeur de tension continue (U) déterminée actuellement se situe dans la fenêtre de tolérance définie par les valeurs limites (U_{max.}, U_{min.}), dans la mesure où simultanément le dispositif de détection de niveau (5) signale une intensité de champ de réception suffisante, et dans lequel l'écart instantané en fréquence (df) par rapport à la fréquence centrale de l'émetteur est représenté par évaluation de la valeur de tension continue (U), délivrée par le discriminateur FM (3), par rapport à la valeur mémorisée (Uₒ) de la tension continue, pour la fréquence centrale de l'émetteur, à l'aide du dispositif (7) d'affichage de réglage d'accord.
